# FASCICULE DE BREVET EUROPEEN

(11) **EP 0 538 121 B1**
(45) Date de publication et mention de la délivrance du brevet: **16.04.1997**
(21) Numéro de dépôt: 92402805.3
(22) Date de dépôt: 14.10.1992
(51) Int. Cl.: G11C 16/06, G11C 5/14

(54) **Dispositif pour générer une tension de programmation d'une mémoire permanente programmable, notamment de type EPROM, procédé et mémoire s'y rapportant**
Anordnung zum Generieren einer Programmierspannung eines programmierbaren Festwertspeichers, insbesondere des EPROM-Typs, und dazugehörige Verfahren und Speicher
Circuit for generating a programming voltage for a programmable read-only memory, especially of an EPROM type, and method and memory relating to it

(30) Priorité: 18.10.1991 FR 9112888
(43) Date de publication de la demande: 21.04.1993
(73) Titulaire: SGS-THOMSON MICROELECTRONICS S.A., 94253 Gentilly Cédex (FR)
(72) Inventeur: Yero, Emilio, F-13100 Aix-en-Provence (FR)
(74) Mandataire: Schmit, Christian Norbert Marie

(56) Documents cités:
- EP-A- 0 352 111
- MICROPROCESSORS AND MICROSYSTEMS vol. 14, no. 8, Octobre 1990, LONDON (GB) pages 543 - 549 ZALES ET AL 'INTEL FLASH EPROM FOR IN-SYSTEM REPROGRAMMABLE NONVOLATILE STORAGE'
- IEEE JOURNAL OF SOLID-STATE CIRCUITS. vol. 22, no. 4, Juillet 1987, NEW YORK US pages 548 - 552 MASUOKA ET AL 'A 256-KBIT FLASH EEPROM USING TRIPLE POLYSILICON TECHNOLOGY'

## Description

La présente invention concerne un dispositif pour générer une tension de programmation d'une mémoire permanente programmable, notamment une mémoire de type EPROM.

Elle vise également un procédé mis en oeuvre dans ce dispositif ainsi qu'une mémoire intégrant ce dispositif.

Lors des opérations de programmation de mémoires programmables, notamment de type EPROM, les générateurs de tension dont ces mémoires sont dotées doivent délivrer, à partir d'une tension externe appliquée, une tension de programmation stabilisée à des cellules mémoires qui représentent une charge équivalente d'impédance sensiblement variable . Or, les dispositifs actuels de génération présentent généralement une impédance de sortie trop élevée pour contribuer à limiter à des niveaux raisonnables les variations de tension de programmation induites par les contraintes inhérentes à la fabrication.

Or des variations de tension excessives provoquent des contraintes sur les composants qui peuvent conduire à leur dégradation et à leur destruction.

Le but de la présente invention est de remédier à ces inconvénients en proposant un dispositif pour générer une tension de programmation d'une mémoire permanente programmable, notamment de type EPROM, à partir d'une source externe de tension continue, comprenant des moyens pour générer une tension de référence.

Suivant l'invention, ce dispositif comprend en outre des moyens pour dupliquer ladite tension de référence agencés selon une structure de miroir de tension et de courant et générant en sortie la tension de programmation, et un transistor MOS suiveur dont le drain et la source sont respectivement reliés à la source externe de tension continue et à la sortie desdits moyens de duplication et dont la grille est reliée à un noeud interne prédéterminé desdits moyens pour générer une tension de référence.

Ainsi, avec le dispositif selon l'invention, on dispose d'une tension de programmation délivrée par un générateur présentant une impédance de sortie considérablement réduite par rapport aux dispositifs de l'art antérieur par le recours à des moyens de duplication mettant en oeuvre une structure de miroir. La boucle de contre-réaction négative réalisée par la liaison entre la grille du transistor suiveur et les moyens de génération de référence, contribue en outre à stabiliser la tension de programmation. Cette boucle présente en pratique un gain négatif élevé par rapport aux variations de la tension de sortie. Ceci procure une auto-adaptation du dispositif selon l'invention à des conditions de courant de charge variables.

Suivant une version avantageuse de l'invention, les moyens pour générer une tension de référence comprennent un premier transistor MOS dont la source est reliée à la source externe de tension continue et un second transistor MOS dont le drain est relié à la masse, un premier, un second et un troisième éléments résistifs reliés en série entre la source externe de tension continue et la masse, la grille du premier transistor MOS étant relié à un noeud de jonction entre les premier et second éléments résistifs tandis que la grille du second transistor MOS est reliée à un noeud de jonction entre les second et troisième éléments résistifs, et les moyens de duplication comprennent un premier transistor MOS miroir dont le drain et la source sont reliées respectivement au drain du premier transistor MOS et à la source du second transistor MOS desdits moyens pour générer une tension de référence.

Selon une forme de réalisation préférée de l'invention, les moyens de duplication comprennent en outre un deuxième transistor MOS miroir dont la grille est reliée à la grille du premier transistor MOS miroir et dont la source constitue la sortie desdits moyens de duplication, et un troisième transistor MOS miroir dont la grille, la source et le drain sont respectivement reliés à la grille du premier transistor MOS des moyens de génération, à la source externe de tension continue et au drain du second transistor MOS miroir.

Suivant un autre aspect de l'invention, le procédé pour générer une tension de programmation d'une mémoire permanente programmable, notamment de type EPROM, à partir d'une source externe de tension continue, comprend une première étape pour générer une tension de référence à partir d'une tension délivrée par ladite source externe de tension continue, le procédé étant mis en oeuvre dans le dispositif selon l'invention et étant caractérisé en ce qu'il comprend en outre une seconde étape pour dupliquer la tension de référence et générer la tension de programmation, et une troisième étape pour stabiliser la tension de programmation.

Suivant une forme préférée de mise en oeuvre du procédé selon l'invention, la troisième étape de stabilisation inclut une étape de contre-réaction dans laquelle la tension de programmation est asservie à la dite tension de référence.

De plus, l'étape de duplication inclut une opération de miroir de courant et de tension de référence.

Le dispositif selon l'invention peut être intégré dans des mémoires permanentes programmables, notamment de type EPROM, dans lesquelles peut également être mis en oeuvre le procédé selon l'invention.

D'autres particularités et avantages de l'invention apparaîtront encore dans la description ci-après. Aux dessins annexés à titre d'exemples non limitatifs :
- la figure 1 est un schéma d'un dispositif générateur représentatif de l'art antérieur ;
- la figure 2 est un schéma d'une forme de réalisation d'un dispositif générateur selon l'invention ; et
- la figure 3 est un schéma d'une autre forme de réalisation d'un dispositif générateur selon l'invention.

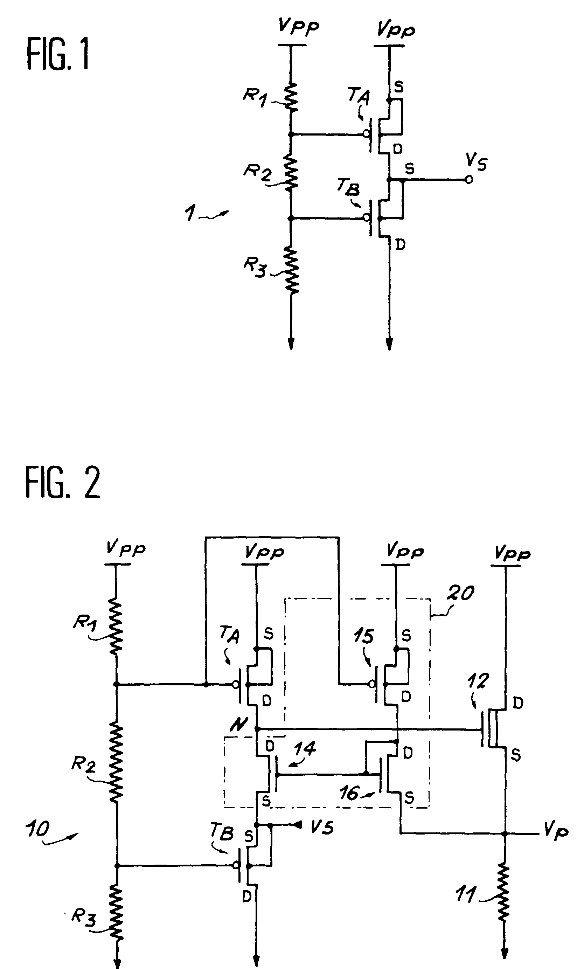

On va maintenant décrire une forme pratique de réalisation de l'invention en référence aux figures 1 à 3.

Le dispositif 10 selon l'invention comprend, en référence à la figure 2, un premier étage assurant la génération d'une tension de référence à partir d'une tension continue Vpp délivrée par une source externe de tension continue (non représentée). Ce premier étage correspond au montage générateur 1 représenté en figure 1 et déjà connu dans l'art antérieur. Un tel circuit 1 comprend un premier, un second et un troisième éléments résistifs R1, R2, R3 reliés en série entre un point au potentiel de la source externe de tension continue Vpp et la masse, un premier transistor MOS TA dont la source est placée au potentiel Vpp et un second transistor MOS TB dont le drain est relié à la masse et dont la source est reliée au drain du premier transistor MOS TA. La grille du premier transistor TA est reliée à un noeud de jonction entre les premier R1 et second R2 éléments résistifs, tandis que la grille du second transistor MOS TB est reliée à un noeud de jonction entre les second R2 et troisième R3 éléments résistifs.

Les premier et second transistors MOS TA, TB sont des transistors à canal p réalisés par implantation et dont le substrat est relié à la source afin de minimiser les tensions de seuil.

On montre aisément que ce circuit 1 génère une tension de sortie Vs sensiblement égale à
Vₚₚ * (R1+R3)/(R1+R2+R3) , qui est indépendante des paramètres de fabrication du circuit tant que les deux transistors TA, TB restent saturés. La tension de sortie du circuit 1 est dans la suite considérée comme tension de référence.

Dans le dispositif selon l'invention, en référence à la figure 2, un circuit de duplication 20 est placé en aval du circuit générateur avec pour objectif de dupliquer la tension de référence sans créer de charge interne pour le générateur. On peut ainsi réduire la sensibilité de la tension de sortie à d'éventuelles variations de courant de charge.

Le circuit de duplication 20, qui met en oeuvre le concept connu en électronique de miroir de tension et de courant, comprend un premier transistor MOS miroir 14 inséré entre les deux premier et second transistors MOS TA, TB du générateur de tension de référence, un second transistor MOS miroir 16 dont la grille est reliée à la grille du premier transistor MOS miroir 14 et dont la source est au potentiel de la tension de sortie Vp, et un troisième transistor MOS miroir 15 dont la source est au potentiel Vpp, la grille reliée à la grille du premier transistor MOS TA et le drain relié au drain du second transistor MOS miroir 16. Le drain et la source du premier transistor MOS miroir 14 sont reliés respectivement au drain du premier transistor MOS TA et à la source du second transistor MOS TB.

Les premier et second transistors MOS miroir 14, 16 sont des transistors réalisés par implantation à canal n tandis que le troisième transistor MOS miroir 15 est un transistor réalisé par implantation à canal p. Il est à noter que les second et troisième transistors MOS miroir 15, 16 ont leurs substrats respectifs reliés respectivement à leur source et leur drain afin de minimiser leur tension de seuil.

Le dispositif 1 selon l'invention comprend un transistor MOS suiveur 12 natif à canal n dont le drain et la source sont reliés respectivement au potentiel Vpp de la source externe de tension continue et à la charge alimentée par le dispositif selon l'invention et représentée de façon schématique par une impédance 11. Cette charge est soumise à la différence de potentiel Vp stabilisée. La grille du transistor suiveur 12 est reliée en un point prédéterminé N à la source du premier transistor MOS TA du générateur de tension de référence. La liaison en ce point N assure la fermeture d'une boucle de contre-réaction négative de la tension de programmation Vp, dont une simulation numérique a montré la remarquable stabilité.

A titre d'exemple, dans une forme effective de réalisation du dispositif selon l'invention, on obtient par simulation informatique une résistance de sortie du générateur égale à 2.7 ohms et une variation de la tension de programmation égale à seulement 81 mV pour une variation de courant de charge typique de 0 à 30 mA.

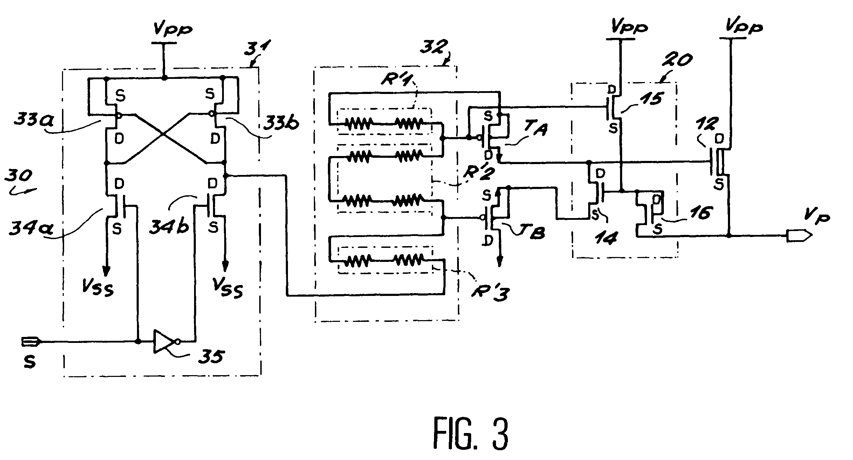

Le dispositif générateur selon l'invention peut bien sûr être associé à d'autres circuits placés en amont ou en aval. A titre d'exemple et en référence à la figure 3, on peut prévoir au sein d'un dispositif générateur 30 l'adjonction en amont d'un circuit 31 de contrôle de la tension d'alimentation délivrée au générateur de tension de référence. Ce circuit de contrôle 31 peut par exemple comprendre un montage symétrique de deux bras de transistors MOS 33a, 34a; 33b, 34b, chaque bras comprenant un premier transistor MOS à canal n commandé respectivement par un signal de commande S et par son inverse logique généré par une porte logique inverseuse 35, et un second transistor MOS à canal p dont la grille est reliée au drain du transistor correspondant de l'autre bras, ces deux derniers transistors ayant chacun leur substrat relié à leur source.

Le point de jonction des deux transistors 33b, 34b du second bras du circuit de contrôle 31 est relié à une première extrémité d'un réseau 32 de résistances R'1, R'2, R'3 implantées dans le substrat du circuit et constituant les trois résistances nécessaires au générateur de tension de référence décrit précédemment. La partie restante du dispositif générateur 30 qui inclut l'étage de duplication et le transistor suiveur est identique au montage de la figure 2 décrit précédemment.

Bien entendu, l'invention n'est pas limitée aux exemples qui viennent d'être décrits et on peut imaginer bien d'autres aménagements et applications sans sortir du cadre de l'invention.

Ainsi, on peut envisager divers modes de réalisation des éléments résistifs inclus dans le générateur de tension de référence. Par ailleurs, le dispositif selon l'invention peut être associé à d'autres circuits de mise en forme ou de protection en fonction des contraintes spécifiques à la mémoire hôte et à ses conditions d'utilisation.

## Revendications

1. Dispositif (10) pour générer une tension de programmation (Vp) d'une mémoire permanente programmable, notamment de type EPROM, à partir d'une source externe de tension continue (Vpp), comprenant des moyens (TA, TB, R1, R2, R3) pour générer une tension de référence (Vs), caractérisé en ce qu'il comprend en outre des moyens (20) pour dupliquer la dite tension de référence (Vs), agencés selon une structure de miroir de tension et de courant et générant en sortie la tension de programmation (Vp), et un transistor MOS suiveur (12) dont le drain et la source sont respectivement reliés à la source externe de tension continue (Vpp) et à la sortie desdits moyens de duplication (20) et dont la grille est reliée à un noeud interne prédéterminé (N) desdits moyens (TA, TB, R1, R2, R3) pour générer une tension de référence.

2. Dispositif (10) selon la revendication 1, caractérisé en ce que les moyens pour générer une tension de référence comprennent un premier transistor MOS (TA) dont la source est reliée à la source externe de tension continue (Vpp) et un second transistor MOS (TB) dont le drain est relié à la masse, et un premier (R1), un second (R2) et un troisième (R3) éléments résistifs reliés en série entre la source externe de tension continue (Vpp) et la masse, la grille du premier transistor MOS (TA) étant reliée à un noeud de jonction entre les premier (R1) et second (R2) éléments résistifs tandis que la grille du second transistor MOS (TB) est reliée à un noeud de jonction entre les second (R2) et troisième (R3) éléments résistifs, et en ce que les moyens de duplication (20) comprennent un premier transistor MOS miroir (14) dont le drain et la source sont reliées respectivement au drain du premier transistor MOS (TA) et à la source du second transistor MOS (TB) desdits moyens (TA, TB, R1, R2, R3) pour générer une tension de référence.

3. Dispositif (10) selon la revendication 2, caractérisé en ce que les moyens de duplication (20) comprennent en outre un deuxième transistor MOS miroir (16) dont la grille est reliée à la grille du premier transistor MOS miroir (14) et dont la source constitue la sortie desdits moyens de duplication, et un troisième transistor MOS miroir (15) dont la grille, la source et le drain sont respectivement reliés à la grille du premier transistor MOS (TA) des moyens de génération (TA, TB, R1, R2, R3), à la source externe de tension continue (Vpp) et au drain du second transistor MOS miroir (16).

4. Dispositif (10) selon les revendications 2 ou 3, caractérisé en ce que la grille du transistor MOS suiveur (12) est reliée au drain du premier transistor MOS (TA) des moyens de génération (TA, TB, R1, R2, R3).

5. Dispositif (10) selon l'une des revendications 2 à 4, caractérisé en ce que les premier (TA) et second (TB) transistors MOS sont des transistors MOS implantés à canal p et ont chacun leur substrat relié à leur source.

6. Dispositif (10) selon la revendication 3 et l'une des revendications 4 ou 5, caractérisé en ce que les premier (14) et second (16) transistors MOS miroir sont des transistors MOS implantés à canal n, le troisième transistor MOS miroir (15) est un transistor MOS implanté à canal p, et en ce que lesdits second (16) et troisième (15) transistors MOS miroir ont respectivement leur drain et leur source reliés respectivement à leur grille et à leur substrat.

7. Dispositif (10) selon l'une des revendications précédentes, caractérisé en ce que le transistor MOS suiveur (12) est un transistor MOS natif à canal n.

8. Dispositif (30) selon l'une des revendications précédentes, caractérisé en ce qu'il comprend en outre des moyens (31) pour contrôler l'alimentation en tension continue desdits moyens (TA, TB, R'1, R'2, R'3) pour générer une tension de référence, par ladite source externe de tension continue (Vpp).

9. Procédé pour générer une tension de programmation d'une mémoire permanente programmable, notamment de type EPROM, à partir d'une source externe de tension continue (Vpp), comprenant une première étape pour générer une tension de référence (Vs) à partir d'une tension délivrée par ladite source externe de tension continue, mis en oeuvre dans le dispositif selon l'une des revendications précédentes, caractérisé en ce qu'il comprend en outre une seconde étape pour dupliquer ladite tension de référence (Vs) et générer ladite tension de programmation (Vp), et une troisième étape pour stabiliser ladite tension de programmation (Vp).

10. Procédé selon la revendication 9, caractérisé en ce que la troisième étape de stabilisation inclut une étape de contre-réaction dans laquelle la tension de programmation (Vp) est asservie à la dite tension de référence (Vs).

11. Procédé selon les revendications 9 ou 10, caractérisé en ce que l'étape de duplication inclut une opération de miroir de courant et de tension de référence.

12. Mémoire permanente programmable, notamment de type EPROM, intégrant le dispositif selon l'une des revendications 1 à 8 ou mettant en oeuvre le procédé selon l'une des revendications 9 à 11.

## Patentansprüche

1. Vorrichtung (10) zum Erzeugen einer Programmierspannung (Vp) eines programmierbaren Festwertspeichers, insbesondere vom EPROM-Typ, ausgehend von einer externen Gleichspannungsquelle (Vpp), mit Mitteln (TA, TB, R1, R2, R3) zum Erzeugen einer Referenzspannung (Vs), **dadurch gekennzeichnet**, daß sie ferner Mittel (20) zum Verdoppeln der Referenzspannung (Vs), die in einer Spiegelstruktur für Spannung und Strom angeordnet sind und am Ausgang eine Programmierspannung (Vp) erzeugen und ein MOS-Folgertransistor (12) umfassen, dessen Drain und Source an die externe Gleichspannungsquelle (Vpp) bzw. den Ausgang der Verdopplungsmittel (20) angeschlossen sind und dessen Gate an einen vorgegebenen internen Knoten (N) der Referenzspannungserzeugungsmittel (TA, TB, R1, R2, R3) angeschlossen ist.

2. Vorrichtung (10) nach Anspruch 1, **dadurch gekennzeichnet**, daß die Referenzspannungserzeugungsmittel umfassen: einen ersten MOS-Transistor (TA), dessen Source an die externe Gleichspannungsquelle (Vpp) angeschlossen ist, und einen zweiten MOS-Transistor (TB), dessen Drain an die Masse angeschlossen ist, und ein erstes (R1), zweites (R2) und drittes (R3) Widerstandselement, die in Reihe zwischen der externen Gleichspannungsquelle (Vpp) und der Masse angeschlossen sind, wobei das Gate des ersten MOS-Transistors (TA) an einen Verbindungsknoten zwischen dem ersten (R1) und dem zweiten (R2) Widerstandselement angeschlossen ist, wohingegen das Gate des zweiten MOS-Transistors (TB) an einen Verbindungsknoten zwischen dem zweiten (R2) und dem dritten (R3) Widerstandselement angeschlossen ist und
daß die Verdopplungsmittel (20) einen ersten MOS-Spiegeltransistor (14) umfassen, dessen Drain und Source jeweils an den Drain des ersten MOS-Transistors (TA) bzw. die Source des zweiten MOS-Transistors (TB) der Referenzspannungserzeugungsmittel (TA, TB, R1, R2, R3) angeschlossen sind.

3. Vorrichtung (10) nach Anspruch 2, **dadurch gekennzeichnet**, daß die Verdopplungsmittel (20) ferner einen zweiten MOS-Spiegeltransistor (16), dessen Gate an das Gate des ersten MOS-Spiegeltransistors (14) angeschlossen ist, und dessen Source den Ausgang der Verdopplungsmittel bildet, und einen dritten MOS-Spiegeltransistor (15) umfassen, dessen Gate, Source.und Drain jeweils an das Gate des ersten MOS-Transistors (TA) der Erzeugungsmittel (TA, TB, R1, R2, R3), an die externe Gleichspannungsquelle (Vpp) bzw. an den Drain des zweiten MOS-Spiegeltransistors (16) angeschlossen sind.

4. Vorrichtung (10) nach den Ansprüchen 2 oder 3, **dadurch gekennzeichnet**, daß das Gate des MOS-Folgertransistors (12) an den Drain des ersten MOS-Transistors (TA) der Erzeugungsmittel (TA, TB, R1, R2, R3) angeschlossen ist.

5. Vorrichtung (10) nach einem der Ansprüche 2 bis 4, **dadurch gekennzeichnet**, daß der erste (TA) und der zweite (TB) MOS-Transistor implantierte p-Kanal-MOS-Transistoren sind, deren Substrat jeweils an ihre Source angeschlossen ist.

6. Vorrichtung (10) nach Anspruch 3 und einem der Ansprüche 4 oder 5, **dadurch gekennzeichnet**, daß der erste (14) und der zweite (16) Spiegeltransistor implantierte n-Kanal-MOS-Transistoren sind, der dritte MOS-Spiegeltransistor (15) ein implantierter p-Kanal-MOS-Transistor ist und bei dem zweiten (16) und dem dritten (15) MOS-Spiegeltransistor ihr Drain und ihre Source jeweils mit ihrem Gate bzw. ihrem Substrat verbunden sind.

7. Vorrichtung (10) nach einem der vorhergehenden Ansprüche, **dadurch gekennzeichnet**, daß der MOS-Folgertransistor (12) ein n-Kanal-MOS-Transistor vom Verarmungstyp ist.

8. Vorrichtung (30) nach einem der vorhergehenden Ansprüche, **dadurch gekennzeichnet**, daß sie ferner Mittel (31) zum Steuern der Gleichspannungsversorgung der Referenzspannungserzeugungsmittel (TA, TB, R'1, R'2, R'3) über die externe Gleichspannungsquelle (Vpp) umfaßt.

9. Verfahren zum Erzeugen einer Programmierspannung für einen programmierbaren Festwertspeicher, insbesondere vom EPROM-Typ, ausgehend von einer externen Gleichspannunsquelle (Vpp), mit einem ersten Schritt zum Erzeugen einer Referenzspannung (Vs) ausgehend von einer von der externen Spannungsquelle abgegebenen Spannung, angewandt in der Vorrichtung nach einem der vorhergehenden Ansprüche, **dadurch gekennzeichnet**, daß es ferner einen zweiten Schritt zum Verdoppeln der Referenzspannung (Vs) und zum Erzeugen der Programmierspannung (Vp) und einen dritten Schritt zum Stabilisieren der Programmierspannung (Vp) umfaßt.

10. Verfahren nach Anspruch 9, **dadurch gekennzeichnet**, daß der dritte Schritt der Stabilisierung einen Gegenkopplungsschritt umfaßt, bei dem die Programmierspannung (Vp) auf die Referenzspannung (Vs) wirkt.

11. Verfahren nach den Ansprüchen 9 oder 10, **dadurch gekennzeichnet**, daß der Verdopplungsschritt einen Referenzstrom- und -spannungsspiegelschritt umfaßt.

12. Programmierbarer Festwertspeicher, insbesondere vom EPROM-Typ, in dem die Vorrichtung nach einem der Ansprüche 1 bis 8 integriert ist oder der das Verfahren nach einem der Ansprüche 9 bis 11 anwendet.

## Claims

1. Device (10) for generating a voltage (Vp) for programming a programmable permanent memory, notably of the EPROM type, from an external DC voltage source (Vpp), comprising means (TA, TB, R1, R2, R3) for generating a reference voltage (Vs), characterised in that it also comprises means (20) for duplicating the said reference voltage (Vs), arranged in a voltage and current mirror structure and generating the programming voltage (Vp) at the output, and a follower MOS transistor (12) whose drain and source are respectively connected to the external DC voltage source (Vpp) and to the output of the said duplication means (20) and whose gate is connected to a predetermined internal node (N) of the said means (TA, TB, R1, R2, R3) for generating a reference voltage.

2. Device (10) according to Claim 1, characterised in that the means for generating a reference voltage comprise a first MOS transistor (TA) whose source is connected to the external DC voltage source (Vpp) and a second MOS transistor (TB) whose drain is connected to ground, and first (R1), second (R2) and third (R3) resistive elements connected in series between the external DC voltage source (Vpp) and ground, the gate of the first MOS transistor (TA) being connected to a junction node between the first (R1) and second (R2) resistive elements whilst the gate of the second MOS transistor (TB) is connected to a junction node between the second (R2) and third (R3) resistive elements, and in that the duplication means (20) comprise a first mirror MOS transistor (14) whose drain and source are connected respectively to the drain of the first MOS transistor (TA) and to the source of the second MOS transistor (TB) of the said means (TA, TB, R1, R2, R3) for generating a reference voltage.

3. Device (10) according to Claim 2, characterised in that the duplication means (20) also comprise a second mirror MOS transistor (16) whose gate is connected to the gate of the first mirror MOS transistor (14) and whose source constitutes the output of the said duplication means, and a third mirror MOS transistor (15) whose gate, source and drain are respectively connected to the gate of the first MOS transistor (TA) of the generation means (TA, TB, R1, R2, R3), to the external DC voltage source (Vpp) and to the drain of the second mirror MOS transistor (16).

4. Device (10) according to Claims 2 or 3, characterised in that the gate of the follower MOS transistor (12) is connected to the drain of the first MOS transistor (TA) of the generator means (TA, TB, R1, R2, R3).

5. Device (10) according to one of Claims 2 to 4, characterised in that the first (TA) and second (TB) MOS transistors are p-channel implanted MOS transistors and each have their substrate connected to their source.

6. Device (10) according to Claim 3 and one of Claims 4 or 6, characterised in that the first (14) and second (16) mirror MOS transistors are n-channel implanted MOS transistors, the third mirror MOS transistor (15) is a p-channel implanted MOS transistor, and in that the said second (16) and third (15) mirror MOS transistors have respectively their drain and source connected respectively to their gate and substrate.

7. Device (10) according to one of the preceding claims, characterised in that the follower MOS transistor (12) is an n-channel native MOS transistor.

8. Device (30) according to one of the preceding claims, characterised in that it also comprises means (31) for controlling the DC voltage supply to the said means (TA, TB, R'1, R'2, R'3) for generating a reference voltage, by the said extemal DC voltage source (Vpp).

9. Method for generating a voltage for programming a programmable permanent memory, notably of the EPROM type, using an external DC voltage source (Vpp), comprising a first step for generating a reference voltage (Vs) from a voltage delivered by the said external DC voltage source, implemented in the device according to one of the preceding claims, characterised in that it also comprises a second step for duplicating the said reference voltage (Vs) and generating the said programming voltage (Vp), and a third step for stabilising the said programming voltage (VP).

10. Method according to Claim 9, characterised in that the third stabilisation step includes a feedback step in which the programming voltage (Vp) is dependent on the said reference voltage (Vs).

11. Method according to Claims 9 or 10, characterised in that the duplication step includes a reference voltage and current mirror operation.

12. Programmable permanent memory, notably of the EPROM type, integrating the device according to one of Claims 1 to 8 or implementing the method according to one of Claims 9 to 11.
